# EUROPEAN PATENT SPECIFICATION

(11) **EP 3 055 885 B1**
(45) Date of publication and mention of the grant of the patent: **30.06.2021**
(21) Application number: 13894581.1
(22) Date of filing: 30.09.2013
(51) Int. Cl.: H01L 29/778, H01L 21/336, H01L 29/51, H01L 29/423, H01L 29/20

(54) **NORMALLY-OFF III-NITRIDE TRANSISTORS WITH HIGH THRESHOLD-VOLTAGE AND LOW ON-RESISTANCE**
IM NORMALSTAND ABGESCHALTETE III-NITRIDTRANSISTOREN MIT HOHER SCHWELLENSPANNUNG UND NIEDRIGEM ANSCHALTWIDERSTAND
TRANSISTORS AU NITRURE III NORMALEMENT ÉTEINTS AVEC SEUIL DE TENSION ÉLEVÉ ET FAIBLE RÉSISTANCE LORS DE L'ALLUMAGE

(43) Date of publication of application: 17.08.2016
(73) Proprietor: HRL Laboratories, LLC, Malibu, CA 90265-4799 (US)
(72) Inventor: CHU, Rongming, Agoura Hills, California 91301 (US); BROWN, David F., Woodland Hills, California 91303 (US); WILLIAMS, Adam J., Los Alamitos, California 90720 (US)
(74) Representative: Farrington, Graham
(86) International application number: PCT/US2013/062750
(87) International publication number: WO 2015/047421

(56) References cited:
- JP-A- 2008 227 501
- US-A1- 2006 194 379
- US-A1- 2010 025 730
- US-A1- 2012 235 160
- US-A1- 2012 261 720
- US-A1- 2013 181 224
- XIE JINQIAO ET AL: "High electron mobility in nearly lattice-matched AlInN/AlN/GaN heterostructure field effect transistors", APPLIED PHYSICS LETTERS, A I P PUBLISHING LLC, US, vol. 91, no. 13, 28 September 2007 (2007-09-28), pages 132116-132116, XP012099407, ISSN: 0003-6951, DOI: 10.1063/1.2794419

## Description

### TECHNICAL FIELD

This disclosure relates to methods of fabricating III-Nitride field effect transistors (FETs) and in particular to normally off FETs.

### BACKGROUND

III-nitride transistors are promising for highspeed and high-power applications, such as power switches, which may be used for motor drivers and power supplies, among other applications. Many of these applications require the transistor to operate in normally-off mode. Normally-off mode operation can be realized by a number of approaches, but typically at the penalty of higher on-resistance and lower output-current.

U.S published Patent Application No. US 2013/0026495 A1 describes a normally-off III-Nitride field-effect transistor and a method for making a normally-off FET.

What is needed is a normally-off FET, which has a minimal penalty in on-resistance. In particular what is desired is a high threshold voltage, preferably greater than one volt, a low on-resistance, preferably less than 20ohm-mm for devices with more than 600V breakdown voltage, and an excellent uniformity in threshold voltage and on-resistance, with preferably less than 10% of standard deviation. The embodiments of the present disclosure answer these and other needs.

US 2010/025730 A1 describes normally-off semiconductor devices. A Group III-nitride buffer layer is provided. A Group III-nitride barrier layer is provided on the Group III-nitride buffer layer. A non-conducting spacer layer is provided on the Group III-nitride barrier layer. The Group III-nitride barrier layer and the spacer layer are etched to form a trench. The trench extends through the barrier layer and exposes a portion of the buffer layer. A dielectric layer is formed on the spacer layer and in the trench and a gate electrode is formed on the dielectric layer. Related methods of forming semiconductor devices are also provided.

### SUMMARY

The claimed invention is defined by the enclosed claims.

A method of fabricating a III-nitride transistor comprises in particular forming a III-nitride channel layer, forming a barrier layer over the channel layer, the barrier layer having a thickness of 1 to 5 nanometers, forming a dielectric layer on top of the barrier layer, forming a source electrode contacting the channel layer, forming a drain electrode contacting the channel layer, etching a gate trench extending through the dielectric layer and barrier layer and having a bottom located within the channel layer so that a distance between an interface of the channel layer and the barrier layer and the bottom of the gate trench is greater than 0 nanometers and less than or equal to 5 nanometers, forming a gate insulator lining the gate trench and extending over the dielectric layer, and forming a gate electrode in the gate trench. In embodiments, the gate electrode may partially extend toward the source electrode and the drain electrode to form an integrated gate field-plate.

These and other features and advantages will become further apparent from the detailed description and accompanying figures that follow. In the figures and description, numerals indicate the various features, like numerals referring to like features throughout both the drawings and the description.

### BRIEF DESCRIPTION OF THE DRAWINGS

FIG. 1 shows a diagram of III-nitride field effect transistor in accordance with the present invention;
FIG. 2 shows a process flow for making a III-nitride field effect transistor in accordance with the present invention; and
FIGs. 3A - 3C shows graphs of typical current - voltage curves for a III-nitride field effect transistor in accordance with the present invention.

### DETAILED DESCRIPTION

In the following description, numerous specific details are set forth to clearly describe various specific embodiments disclosed herein. One skilled in the art, however, will understand that the presently claimed invention may be practiced without all of the specific details discussed below. In other instances, well known features have not been described so as not to obscure the invention.

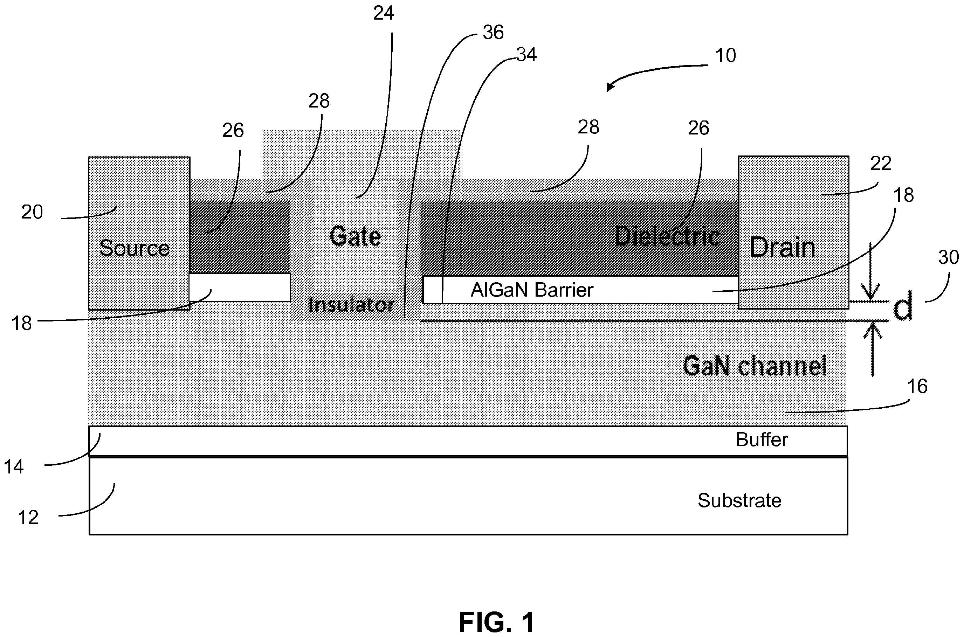

FIG. 1 shows an elevation sectional view of a device structure for a FET 10 in accordance with the present disclosure. The FET has a buffer layer 14 formed on a substrate 12. A channel layer 16 is formed on the buffer layer 14 and a barrier layer 18, is formed on the channel layer 16.

The substrate 12 material may be silicon (Si), silicon carbide (SiC), sapphire, gallium nitride (GaN), or aluminum nitride(AlN).

The buffer layer 14 may be a stack of III-Nitride materials grown on the substrate 12 by chemical vapor deposition or molecular beam epitaxy.

The channel layer 16 is a III-Nitride material, namely GaN, grown on the butter layer 14 by chemical vapor deposition or molecular beam epitaxy. Typically the channel layer 16 is an undoped GaN layer with the thickness ranging from 5 nanometers to a few micrometers.

The barrier layer 18 is 1-5 nanometers thick. The barrier layer 18 is AlGaN, for example with a 25% Al composition.

A dielectric layer 26 is formed on top of the barrier layer 18, and may be SiN and have a thickness of 10 to 200 nanometers and may be typically 100 nm thick. The dielectric layer 26 may be deposited by MOCVD and LPCVD.

A source electrode 20 and a drain electrode 22 are in contact with the channel layer 16 and extend through the dielectric layer 26 and the barrier layer 18. The source electrode 20 and drain electrode 22 are on opposite ends of the channel layer 16.

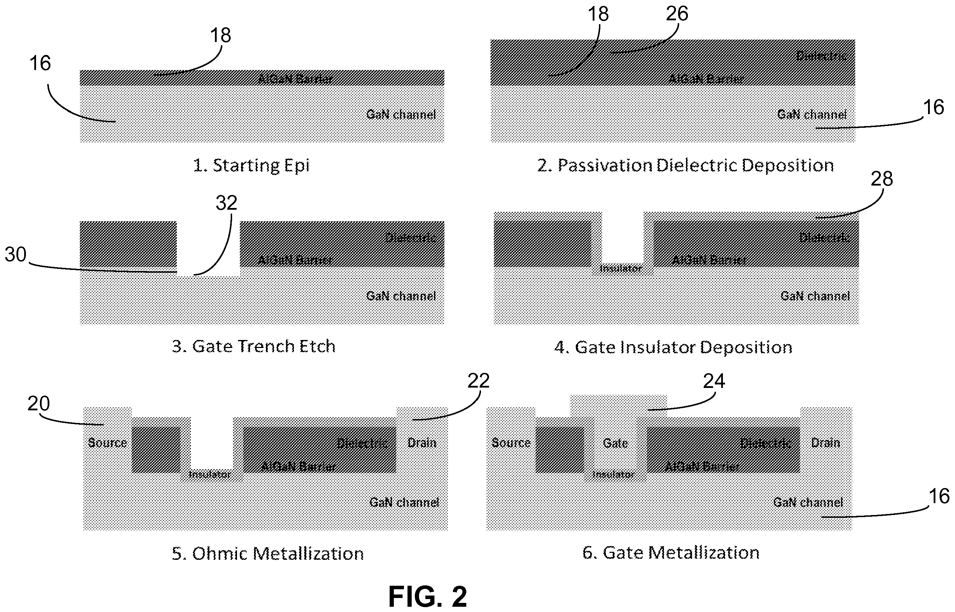

A gate trench 32, as seen in FIG. 2 step 3, is formed through the dielectric layer 26 and the barrier layer 18. The bottom of the gate trench 32 is located within the channel layer 16, and extends below the barrier layer 18 and into the channel layer 16 by a vertical distance d 30. This distance d 30 is between a barrier layer and channel layer interface 34 and the bottom 36 of the gate trench 32, and is between 0 and 5 nanometers (nm). The distance d needs to be greater than 0 nm for normally-off operation, and needs to be as small as possible to in order to minimize the on-resistance.

A gate insulator 28 is formed in the gate trench 32 and over the dielectric 26. The gate insulator 28 may include a stack of: a layer of single-crystalline AlN at the bottom of the gate trench 32, which is up to 2nm thick and typically 1nm thick; a layer of polycrystalline AlN on the single crystalline AlN layer, which is 5nm to 50nm thick and typically 25nm thick; and an insulating layer, such as AL₂O₃, AlON, or SiN, formed on the polycrystalline AlN layer, which is 1nm to 50nm thick and typically 5nm thick.

The single crystalline AlN is preferably grown at a temperature greater than 600C, and less than 1100C. A preferred temperature for growing the single crystalline AlN is 900C. The poly crystalline AlN is preferably grown at a temperature greater than 300C, and less than 900C, and a preferred temperature is 600C.

The gate insulator 28 stack makes the FET 10 a normally off FET. Under a positive gate bias the FET has a very low gate leakage, and a high-mobility electron channel is formed at the interface between the gate insulator 18 and the channel layer 16.

The single-crystalline AlN layer of the gate insulator stack 28 provides a high-quality interface for electron transport in the channel layer 16 without causing accumulation of a two-dimensional electron gas (2DEG) in the channel. Furthermore, the single crystalline AlN layer provides an energy barrier to prevent electron trapping into the poly-crystalline AlN layer.

The polycrystalline AlN layer is the main layer supporting the gate bias, and the oxidized AlN layer serves a blocking layer to leakage paths through grain boundaries of the polycrystalline AlN layer.

The gate insulator is formed over the dielectric 26 and extends to the source electrode 20 and to the drain electrode 22.

A gate electrode 24 is formed over the gate insulator 28 in the gate trench 32 and may extend partially toward the source electrode 20 and partially toward the drain electrode 22 to form an integrated gate field-plate.

Controlling the depth of gate trench 32 achieves a normally-off operation, while minimizing the resistance components associated with the vertical distances between the barrier layer/channel layer interface and the bottom of the gate trench 32. As discussed above, the distance d 30 needs to be greater than 0 nm for normally-off operation, and needs to be as small as possible to in order to minimize the on-resistance.

The barrier layer 18, which is typically 5nm, allows accurate control of the gate trench 32 depth 30 with high uniformity. When etching the gate trench through the barrier layer, some over etch is always the result and about 10% over etch is typical. So if the barrier layer 18 were 50 nm thick, then the over etch would be on the order of 5 nm, which would be a relatively large over etch. With a barrier layer 18 of only about 5 nm thickness, the over etch is more controlled and a 10% over etch would be only 0.5 nm. Therefore, a barrier layer 18 that is only about 5nm, allows the distance d 30 to be better controlled.

FIG. 2 shows a process flow for making a III-nitride field effect transistor in accordance with the present disclosure. In step 1 the epi layers are grown for the channel layer 16 and the barrier layer 18. In step 2 dielectric layer 26 is deposited on the barrier layer 18. Then in step 3 a gate trench 32 is etched through the dielectric layer 26 and the barrier layer 18 and then etched into the channel layer 16 by a distance d 30. In step 4 the gate insulator stack 28 is formed. Then in step 5 the source electrode 20 and the drain electrode 22 are formed by etching through the gate insulator 28, the dielectric 26, and the barrier layer 18 and then forming metal for the source electrode 20 and the drain electrode 22. Next in step 6, the gate electrode 24 is metallized.

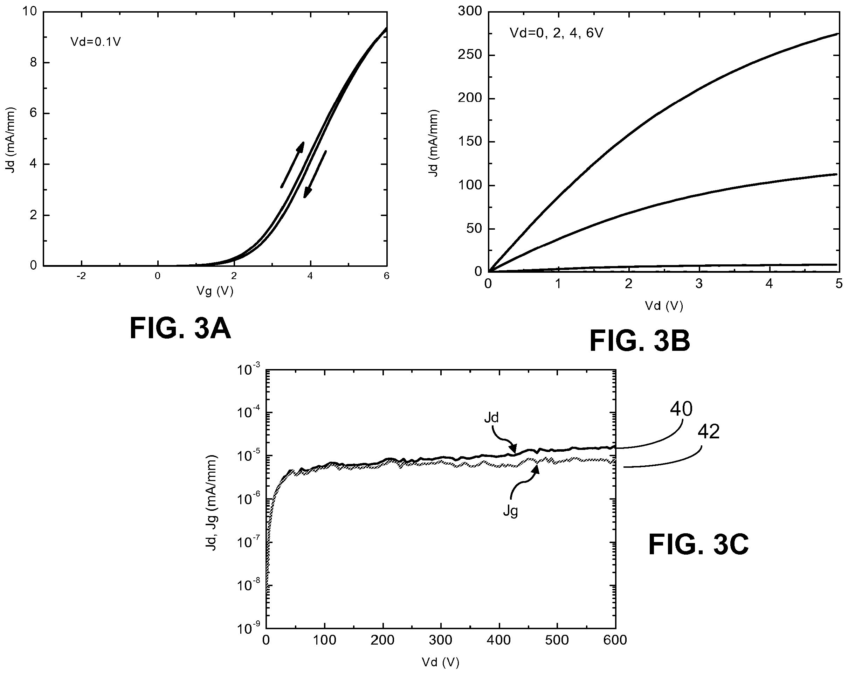

FIGs. 3A - 3C show graphs of typical current - voltage curves for a III-nitride field effect transistor in accordance with the present disclosure. The graphs indicate that the threshold voltage is at least 1V, that the on-resistance is 20 ohm-mm or less, and that the breakdown voltage is at least 600V.

Having now described the invention in accordance with the requirements of the patent statutes, those skilled in this art will understand how to make changes and modifications to the present invention to meet their specific requirements or conditions.

The foregoing Detailed Description of exemplary and preferred embodiments is presented for purposes of illustration and disclosure in accordance with the requirements of the law. It is not intended to be exhaustive nor to limit the invention to the precise form(s) described, but only to enable others skilled in the art to understand how the invention may be suited for a particular use or implementation. The possibility of modifications and variations will be apparent to practitioners skilled in the art. No limitation is intended by the description of exemplary embodiments which may have included tolerances, feature dimensions, specific operating conditions, engineering specifications, or the like, and which may vary between implementations or with changes to the state of the art, and no limitation should be implied therefrom. Applicant has made this disclosure with respect to the current state of the art, but also contemplates advancements and that adaptations in the future may take into consideration of those advancements, namely in accordance with the then current state of the art.

Reference to a claim element in the singular is not intended to mean "one and only one" unless explicitly so stated. Moreover, no element, component, nor method or process step in this disclosure is intended to be dedicated to the public regardless of whether the element, component, or step is explicitly recited in the Claims.

## Claims

1. A method of fabricating a III-nitride transistor comprising:
forming a III-nitride channel layer (16);
forming a barrier layer (18) over the channel layer (16), the barrier layer (18) having a thickness of 1 to 5 nanometers;
forming a dielectric layer (26) on top of the barrier layer (18);
forming a source electrode (20) contacting the channel layer (16);
forming a drain electrode (22) contacting the channel layer (16);
etching a gate trench extending through the dielectric layer (26) and the barrier layer (18) and having a bottom (36) located within the channel layer (16) so that a distance between an interface (34) of the channel layer (16) and the barrier layer (18) and the bottom (36) of the gate trench is greater than 0 nanometers and less than or equal to 5 nanometers;
forming a gate insulator (28) lining the gate trench and extending over the dielectric layer (26); and
forming a gate electrode (24) in the gate trench;
wherein forming the gate insulator (28) comprises forming a single-crystalline AlN layer at the bottom (36) of the gate trench; forming a polycrystalline AlN layer on the single-crystalline AlN layer; and forming an insulating layer comprising Al₂O₃, AlON, or SiN on the polycrystalline AlN layer;
wherein:
the channel layer (16) is GaN; and
the barrier layer (18) is AlGaN.

2. The method of claim 1 wherein:
the single-crystalline AlN layer is up to 2nm thick;
the polycrystalline AlN layer is 5nm to 50nm thick; and
the insulating layer is 1nm to 50nm thick.

3. The method of claim 1 wherein:
the single-crystalline AlN layer is formed at a temperature greater than 600 degrees Celsius and lower than 1100 degrees Celsius; and
the polycrystalline AlN layer is formed at a temperature greater than 300 degrees Celsius and lower than 900 degrees Celsius.

4. The method of claim 1 wherein:
forming the gate electrode (24) further comprises forming the gate electrode (24) to extend partially toward the source electrode (20) and the drain electrode (22) to form an integrated gate field-plate.

## Patentansprüche

1. Verfahren zur Herstellung eines III-Nitrid-Transistors, wobei das Verfahren folgendes umfasst:
Ausbilden einer III-Nitrid-Kanalschicht (16);
Ausbilden einer Sperrschicht (18) über der Kanalschicht (16), wobei die Sperrschicht (18) eine Dicke von 1 bis 5 Nanometern aufweist;
Ausbilden einer dielektrischen Schicht (26) auf der Sperrschicht (18);
Ausbilden einer Source-Elektrode (20), die sich in Kontakt mit der Kanalschicht (16) befindet;
Ausbilden einer Drain-Elektrode (22), die sich in Kontakt mit der Kanalschicht (16) befindet;
Ätzen eines Gate-Grabens, der sich durch die dielektrische Schicht (26) und die Sperrschicht (18) erstreckt und einen Boden (36) aufweist, der sich in der Kanalschicht (16) befindet, so dass ein Abstand zwischen einer Grenzfläche (34) der Kanalschicht (16) und der Sperrschicht (18) und dem Boden (36) des Gate-Grabens größer ist als 0 Nanometer und kleiner oder gleich 5 Nanometern;
Ausbilden eines Gate-Isolators (28), der den Gate-Graben auskleidet und sich über die dielektrische Schicht (26) erstreckt; und
Ausbilden einer Gate-Elektrode (24) in dem Gate-Graben;
wobei das Ausbilden des Gate-Isolators (28) das Ausbilden einer einkristallinen AlN-Schicht an dem Boden (36) des Gate-Grabens umfasst; das Ausbilden einer polykristallinen AlN-Schicht auf der einkristallinen AlN-Schicht; und das Ausbilden einer isolierenden Schicht, die Al₂O₃, AION oder SiN umfasst, auf der polykristallinen AlN-Schicht;
wobei die Kanalschicht (16) GaN ist; und
wobei die Sperrschicht (18) AIGaN ist.

2. Verfahren nach Anspruch 1, wobei:
die einkristallinen AlN-Schicht bis zu 2 nm dick ist;
die polykristalline AlN-Schicht 5 nm bis 50 nm dick ist; und
die isolierende Schicht 1 nm bis 50 nm dick ist.

3. Verfahren nach Anspruch 1, wobei:
die einkristalline AlN-Schicht bei einer Temperatur von über 600 Grad Celsius und von unter 1.100 Grad Celsius ausgebildet wird; und
die polykristalline AlN-Schicht bei einer Temperatur von über 300 Grad Celsius und von unter 900 Grad Celsius ausgebildet wird.

4. Verfahren nach Anspruch 1, wobei:
das Ausbilden der Gate-Elektrode (24) ferner das das Ausbilden der Gate-Elektrode (24) umfasst, so dass sich diese teilweise in Richtung der Source-Elektrode (20) und der Drain-Elektrode (22) erstreckt, um eine Feldplatte mit integriertem Gate zu bilden.

## Revendications

1. Procédé de fabrication d'un transistor au nitrure III comprenant les étapes consistant à :
former une couche de canal au nitrure III (16) ;
former une couche de barrière (18) sur la couche de canal (16), la couche de barrière (18) ayant une épaisseur de 1 à 5 nanomètres ;
former une couche diélectrique (26) sur le dessus de la couche de barrière (18) ;
former une électrode de source (20) entrant en contact avec la couche de canal (16) ;
former une électrode de drain (22) entrant en contact avec la couche de canal (16) ;
graver un sillon de grille s'étendant à travers la couche diélectrique (26) et la couche de barrière (18) et ayant un fond (36) situé au sein de la couche de canal (16) de telle sorte qu'une distance entre une interface (34) de la couche de canal (16) et de la couche de barrière (18) et le fond (36) du sillon de grille soit supérieure à 0 nanomètre et inférieure ou égale à 5 nanomètres ;
former un isolant de grille (28) revêtant le sillon de grille et s'étendant sur la couche diélectrique (26) ; et
former une électrode de grille (24) dans le sillon de grille ;
l'étape consistant à former l'isolant de grille (28) comprenant les étapes consistant à former une couche d'AlN monocristalline au fond (36) du sillon de grille ; former une couche d'AlN polycristalline sur la couche d'AlN monocristalline ; et former une couche isolante comprenant Al₂O₃, AlON ou SiN sur la couche d'AlN polycristalline ;
la couche de canal (16) étant du GaN ; et
la couche de barrière (18) étant de l'AlGaN.

2. Procédé selon la revendication 1 :
la couche d'AlN monocristalline étant de jusqu'à 2 nm d'épaisseur ;
la couche d'AlN polycristalline étant de 5 nm à 50 nm d'épaisseur ; et
la couche isolante étant de 1 nm à 50 nm d'épaisseur.

3. Procédé selon la revendication 1 :
la couche d'AlN monocristalline étant formée à une température supérieure à 600 degrés Celsius et inférieure à 1 100 degrés Celsius ; et
la couche d'AlN polycristalline étant formée à une température supérieure à 300 degrés Celsius et inférieure à 900 degrés Celsius.

4. Procédé selon la revendication 1 :
l'étape consistant à former l'électrode de grille (24) comprenant en outre l'étape consistant à former l'électrode de grille (24) afin qu'elle s'étende partiellement vers l'électrode de source (20) et l'électrode de drain (22) afin de former une plaque à effet de champ à grille intégrée.
